Europäisches Patentamt

European Patent Office

Office européen des brevets

(11) Publication number: **0 088 967**
**B1**

## (12) EUROPEAN PATENT SPECIFICATION

(45) Date of publication of patent specification: **16.12.87**

(51) Int. Cl.⁴: **H 01 L 21/268**, H 01 L 29/743

(21) Application number: **83102146.4**

(22) Date of filing: **04.03.83**

(54) Laser treatment of thyristor to provide overvoltage self-protection.

(30) Priority: **11.03.82 US 357106**

(43) Date of publication of application:
**21.09.83 Bulletin 83/38**

(45) Publication of the grant of the patent:
**16.12.87 Bulletin 87/51**

(84) Designated Contracting States:
**BE DE FR GB**

(56) References cited:
**DE-A-2 712 114**
**DE-A-2 721 912**
**DE-A-2 928 685**

**IEDM INTERNATIONAL ELECTRON DEVICES MEETING, 7th-9th December 1981, Washington, D.C., pages 410-413, IEEE, New York, US; J.X. PRZYBYSZ et al.:"Thyristors with overvoltage self-protection"**

(73) Proprietor: **WESTINGHOUSE ELECTRIC CORPORATION**
**Westinghouse Building Gateway Center**
**Pittsburgh Pennsylvania 15222 (US)**

(72) Inventor: **Przybysz, John X.**
**168 Deerfield Drive**
**Pittsburgh Pennsylvania (US)**
Inventor: **Fiedor, Richard J.**
**242 Richland Avenue**
**Pittsburgh, Pennsylvania (US)**

(74) Representative: **Fleuchaus, Leo, Dipl.-Ing. et al**
**Fleuchaus & Wehser Melchiorstrasse 42**
**D-8000 München 71 (DE)**

Courier Press, Leamington Spa, England.

## Description

The present invention is generally in the field of power semiconductor devices generally and more specifically related to overvoltage protection of thyristors.

Typically overvoltage protection of a thyristor employs an avalanche current in the gate region to trigger the thyristor. The avalanching is achieved by etching a deep well, approximately 10 mils, in the gate region after an aluminum diffusion and before a gallium diffusion is carried out. The avalanche voltage is determined by the depth and profile of the etched well.

The use of avalanching for self protection will succeed or fail depending on whether the avalanche voltage is less than or more than the edge breakdown voltage of the device.

The use of avalanching necessarily involves some derating of the electrical parameters of the device. Particularly, there is a derating of the forward blocking voltage, $V_{DRM}$, along with an attendant increase in forward drop, $V_F$, for the same $V_{DRM}$.

A major shortcoming of the etched well protection system is the requirement that the well be formed relatively early in the wafer fabrication processing, before the blocking capability of the thyristor can be measured.

A deep well that results in avalanching at 2800 volts provides no protection to a thyristor which experiences edge breakdown at 2700 volts. On the other hand, a 2800 volt avalanche is too much derating for a thyristor which could block 3200 volts.

The deep well avalanche method leaves the process engineer the choice between high yield with greatly derated thyristors or a low yield with only slightly derated devices.

A thyristor with overvoltage self protection provided with a deep well etched in the gate region such that distructive edge firing is avoided is known from the article of J. X. Przybysz et al published in IEDM Intern. Electr. Devices Meeting 7th-9th December 1981, p. 410—413 IEEE Washington D.C.

The principal object of the invention is to provide an improved manufacturing process for thyristors.

The present invention resides broadly in a process for making a thyristor with overvoltage self protection such as recited in claim 1.

For a better understanding of the present invention, reference should be had to the following detailed description and drawing, of which:

Figure 1 is a side view, in section, of a thyristor being processed in accordance with the teachings of this invention;

Fig. 2 is a side view, in section, of a thyristor processed in accordance with the teachings of this invention; and

Figs. 3 and 4 are IV traces of a thyristor before and after processing in accordance with the teachings of this invention.

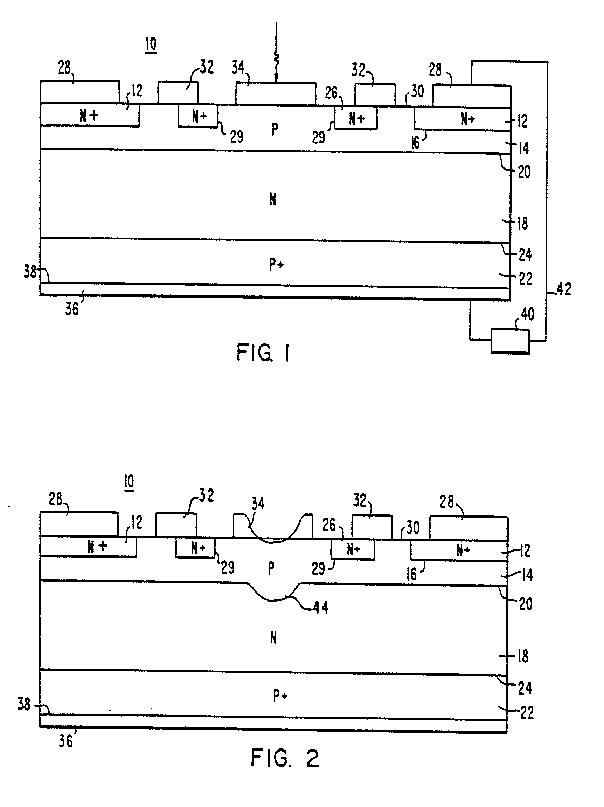

With reference to Fig. 1, there is shown a thyristor 10.

The thyristor 10 is a typical thyristor known to those skilled in the art. The thyristor 10 comprised of silicon has a cathode emitter region 12 which is of N+ type conductivity doped to a concentration of from $10^{18}$ to $5 \times 10^{21}$ atoms/cc. Typically, the cathode emitter region has a thickness of from 15 to 20 microns. There is a cathode base region 14 adjacent to the cathode emitter region. The cathode base region 14 is of P type conductivity and doped to a concentration of from $10^{15}$ to $10^{17}$ atoms/cc. Typically, the cathode base region has a thickness of from 70 to 90 microns. There is a PN junction 16 between regions 12 and 14.

Adjacent to the cathode emitter base region 14 is an anode base region 18. The anode base region 18 is of N type conductivity and doped to a concentration of from $10^{13}$ to $10^{17}$ atoms/cc. The thickness of the anode base region is dependent on the breakdown voltage capability desired for the thyristor. Typically, the anode base region will have a thickness of one micron for each 10 volts of breakdown voltage desired.

There is a PN junction 20 between regions 14 and 18.

Anode emitter region 22 is adjacent to the anode base region 18. The anode emitter region 22 is of P+ type conductivity and is doped to a concentration of from $10^{18}$ to $5 \times 10^{21}$ atoms/cc. Typically, the anode base region has a thickness of from 70 to 90 microns.

There is a PN junction 24 between regions 18 and 22.

There is also an auxiliary emitter or floating gate region 26 formed in the cathode base region 14 and spaced apart from the cathode emitter region 12. The auxiliary emitter or floating gate region 26 is of N type conductivity and doped to a concentration of from $10^{18}$ to $5 \times 10^{21}$. There is a PN junction 29 between regions 26 and 12.

An aluminum ohmic contact 28, referred to as an emitter contact, is affixed to the cathode emitter contact 12 on top surface 30 of the thyristor 10.

A second aluminum ohmic contact 32 is affixed to the auxiliary emitter or floating gate region 26 on top surface 30 of the thyristor 10. The ohmic contact 32 is in ohmic electrical contact with both the auxiliary emitter region 26 and the cathode base region 14 and bridges the PN junction 29 where the junction 29 intersects surface 30.

A gate contact 34 is disposed on surface 30 in ohmic electrical contact with cathode base region 14.

The contacts 28, 32 and 34 all disposed on top surface 30 of the thyristor 10 are spaced apart from each other as shown in Fig. 1.

An anode emitter contact 36, preferably of molybdenum, is affixed to bottom surface 38 of the thyristor 10 in ohmic electrical contact with the anode emitter region 22.

Thyristors of the type thus far described are generally edge fired thyristors.

In practising the teachings of this invention, a curve tracer 40 is electrically connected between the cathode emitter contact 28 and the anode emitter contact 36 by an electrical conductor 42.

The IV characteristic of the thyristor is measured using the curve tracer.

A laser is then used to pulse the thyristor 10 at approximately the center of the cathode base region, i.e., the center of the gating region, and the IV characteristic of the thyristor is measured after each pulse to determine the blocking voltage. The laser pulsing is continued until the desired blocking voltage is realized.

The laser used in practising this invention may be a ruby laser, a $CO_2$ laser, argon laser or a YAG laser.

Satisfactory results have been realized with pulse widths varying from about 20 microseconds to about 100 seconds and energies per pulse from 200 milli joules for ruby lasers to 400 watts for $CO_2$ lasers.

It should be understood that the pulse width and energy per pulse are not critical since the pulsing can be repeated until the desired results are achieved.

With reference to Fig. 2, there is shown the thyristor 10 after being pulsed one or more times by the laser.

The laser pulses have melted the aluminum gate contact 34 and the molten aluminum dissolves some of the silicon and the laser pulse melts some of the silicon. The result is that PN junction 20 is driven farther into the body of silicon in the center of the gating region, denoted as 44 in Fig. 2, due to the melting and resolidification of the silicon. This reshaping of the PN junction 20 causes the thyristor to undergo avalanche breakdown at voltages slightly less than the surface breakdown voltage.

The laser pulsing creates a localized weak spot in the gating region of the forward blocking junction, PN junction 20. The laser induced weak spot causes the forward blocking function to break down in the central gating region and the thyristor is protected against an overvoltage.

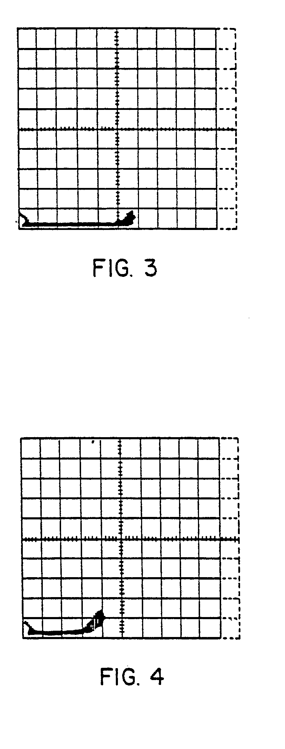

With reference to Figs. 3 and 4, there is shown the IV characteristic of a thyristor processed in accordance with the teachings of this invention.

The thyristor whose IV characteristic is shown in Figs. 3 and 4 had the configuration shown in Fig. 1.

The cathode emitter region had a thickness of 15 microns, was of N type conductivity and was doped to a surface concentration of $10^{20}$ atoms/cc.

The cathode base region had a thickness of 75 microns, was of P type conductivity and was doped to a concentration of $10^{17}$ atoms/cc.

The anode base region had a thickness of 120 microns, was of N type conductivity and doped to a concentration of $5 \times 10^{13}$ atoms/cc.

The anode emitter region had a thickness of 75 microns, was of P type conductivity and doped to a concentration of $10^{17}$ atoms/cc.

The thyristor had an auxiliary emitter or floating gate having a thickness of 15 microns, was of N type conductivity and doped to a surface concentration of $10^{20}$ atoms/cc.

The thyristor was connected to a curve tracer as shown in Fig. 1 and the IV characteristic was measured. The result of this measurement is shown in Fig. 3. The device had a forward blocking voltage of approximately 1160 volts.

The thyristor was then pulsed three times with a ruby laser having a pulse width of 100 microseconds and an energy level of 200 milli joules. No change was measured after the first two pulses, however, as shown in Fig. 4, after the third pulse the thyristors forward blocking voltage was reduced to approximately 800 volts.

In discussing Figs. 1 and 2, it was shown and stated that the laser pulse causes some melting of the aluminum gate contact 34 is melted by the laser pulse. In addition, the aluminum contact can also cause some scattering of the laser pulse.

Therefore, in some situations, it is preferred that the thyristor be pulsed with the laser and the gate contact then be affixed.

## Claims

1. A process for making a thyristor with overvoltage self protection comprising the step of: pulsing the general center of a gating region of the thyristor with at least one pulse of laser radiation in order to reshape (44) the pn junction (20) between the anode base region and cathode base region, such that the blocking voltage of said thyristor is altered and destructive edge firing is prevented.

2. A process according to claim 1 wherein the current-voltage (I—V) characteristics of said thyristor are measured after each pulse.

3. A process according to claim 1 or 2 wherein the laser radiation is selected from the radiation group consisting of ruby laser radiation, $CO_2$ laser radiation, YAG laser radiation and argon laser radiation.

4. A process according to claim 2 wherein said laser radiation is ruby laser radiation.

5. A process according to any of the preceding claims wherein the pulse width of the laser radiation is from 20 to 100 micro-seconds.

6. A process according to any of the preceding claims wherein the energy of each pulse is approximately 200 milli joules.

## Patentansprüche

1. Verfahren zur Herstellung eines Thyristors mit einem Überspannungsselbstschutz mit dem Verfahrensschritt: Beaufschlagen des Hauptzentralbereiches einer Gatezone des Thyristors mit zumindest einem Laserimpuls, um den pn-Übergang (20) zwischen der Anoden-Basiszone und der Kathoden-Basiszone derart umzuformen (44), daß sich die Sperrspannung des Thyristors ändert und schädliche Kantenzünddurchbrüche verhindert werden.

2. Verfahren nach Anspruch 1, dadurch gekennzeichnet, daß die Strom-Spannungscharakteristik (I—V) des Thyristors nach jeder Impulseinwirkung gemessen wird.

3. Verfahren nach Anspruch 1 oder 2, dadurch gekennzeichnet, daß als Laserstrahlung die Strah-

lung eines Rubinlasers, eines $CO_2$-Lasers, eines JAG-Lasers oder eines Argon-Lasers Verwendung findet.

4. Verfahren nach Anspruch 2, dadurch gekennzeichnet, daß ein Rubinlaser Verwendung findet.

5. Verfahren nach einem der vorausgehenden Ansprüche, dadurch gekennzeichnet, daß die Impulsbreite der Laserstrahlung einer Zeitdauer von 20 bis 100 Mikrosekunden entspricht.

6. Verfahren nach einem der vorausgehenden Ansprüche, dadurch gekennzeichnet, daß die Energie jedes einzelnen Impulses etwa 200 Millijoule beträgt.

## Revendications

1. Procédé de fabrication d'un thyristor avec auto-protection contre les surtensions, comprenant l'étape d'impulsion du centre générale d'une région de déclenchement du thyristor avec au moins une impulsion de rayonnement laser afin de reformer (44) la jonction PN (20) entre la région anode-base et la région cathode-base, de sorte que la tension de blocage dudit thyristor est modifiée et qu'un amorçage marginal destructif est évité.

2. Procédé selon la revendication 1, dans lequel les caractéristiques intensité-tension (I—V) dudit thyristor sont mesurées après chaque impulsion.

3. Procédé selon la revendication 1 ou 2, dans lequel le rayonnement laser est sélectionné dans le groupe de rayonnement comprenant le rayonnement laser à rubis, le rayonnement laser à $CO_2$, le rayonnement laser à YAG et le rayonnement laser à argon.

4. Procédé selon la revendication 2, dans lequel ledit rayonnement laser est un rayonnement laser à rubis.

5. Procédé selon l'une quelconque des revendications précédentes, dans lequel la largeur d'impulsion du rayonnement laser est de 20 à 100 microsecondes.

6. Procédé selon l'une quelconque des revendications précédentes, dans lequel l'énergie de chaque impulsion est approximativement de 200 millijoules.

FIG. 1

FIG. 2

FIG. 3

FIG. 4